## Europäisches Patentamt

## European Patent Office

## Office européen des brevets

(11) Veröffentlichungsnummer: **0 293 704**
**A2**

(12) **EUROPÄISCHE PATENTANMELDUNG**

(21) Anmeldenummer: 88108192.1

(22) Anmeldetag: 21.05.88

(51) Int. Cl.⁴: **G03F 7/10**

(30) Priorität: 01.06.87 US 56032

(43) Veröffentlichungstag der Anmeldung:
07.12.88 Patentblatt 88/49

(84) Benannte Vertragsstaaten:
**AT CH DE FR GB IT LI NL**

(71) Anmelder: **HOECHST CELANESE CORPORATION**
**Route 202-206 North**
**Somerville, N.J. 08876(US)**

(72) Erfinder: **Sangya, Jain**
**891 Ardsley Lane**
**Bridgewater New Jersey 08807(US)**
Erfinder: **Ranque, Pilarcita (geb. Labial)**
**538 Andria Ave Unit 277**
**Somerville New Jersey 08876(US)**

(74) Vertreter: **Euler, Kurt Emil, Dr. et al**
**HOECHST AG - Werk KALLE Patentabteilung**
**Postfach 3540 Rheingaustrasse 190**
**D-6200 Wiesbaden(DE)**

(54) **Aufzeichnungsmaterial mit einer wasserlöslichen Kontrastverstärkungsschicht.**

(57) Es wird ein Aufzeichnungsmaterial beschrieben, das im wesentlichen aus einem Träger, einer darauf aufgebrachten lichtempfindlichen Schicht, enthaltend ein in Wasser unlösliches, in wäßrigem Alkali und in organischen Lösungsmitteln lösliches, zumindest aber quellbares Bindemittel und ein o-Chinondiazid und einer Kontrastverstärkungsschicht besteht, die ein durch Licht entfärbbares Diazoniumsalz sowie ein stark saures, in Wasser lösliches und filmbildendes Polymeres enthält. Das Aufzeichnungsmaterial ist grundsätzlich positiv arbeitend, kann aber nach Zugabe eines Vernetzungsmittels zur lichtempfindlichen Schicht und einer erfolgten Vernetzung negativ arbeitend sein.

Durch Anwendung der stark sauren Polymeren wird die Stabilität der Kontrastverstärkungsschicht gewährleistet. Gleichzeitig kann diese Schicht extrem dünn ausgebildet werden, wodurch sich im Vergleich zu Kontrastverstärkungsschichten, die keine polymere Säuren enthalten, eine deutliche Steigerung des Bildauflösungsvermögen und des Entwicklungskontrasts ergibt.

## Aufzeichnungsmaterial mit einer wasserlöslichen Kontrastverstärkungsschicht

Die vorliegende Erfindung betrifft ein Aufzeichnungsmaterial, im wesentlichen bestehend aus einem Träger, einer darauf aufgebrachten lichtempfindlichen Schicht, enthaltend ein in Wasser unlösliches, in wäßrigem Alkali und organischen Lösemitteln aber lösliches, zumindest aber quellbares Bindemittel und ein o-Chinondiazid, sowie einer Kontrastverstärkungsschicht, enthaltend ein durch Licht entfärbbares Diazoniumsalz und ein Polymeres als Bindemittel.

Die Herstellung von positiv-arbeitenden lichtempfindlichen Gemischen ist bekannt und wird zum Beispiel in US-A-3,666,473, US-A-4,115,128 und US-A-4,173,470 beschrieben. Dabei handelt es sich um Mischungen aus alkalilöslichen Phenolformaldehyd-Novolakharzen als Bindemittel in Verbindung mit insbesondere substituierten Naphthochinondiazidverbindungen als lichtempfindliche Substanzen. Die Harze und lichtempfindlichen Substanzen sind in einem organischen Lösemittel oder Lösemittelgemisch gelöst und als dünne Schicht bzw. Beschichtung auf einen für den vorgesehenen Verwendungszweck geeigneten Schichtträger aufgebracht.

Die Novolakharzkomponente dieser lichtempfindlichen Gemische ist in wäßrig-alkalischen Lösungen löslich, je doch nicht die lichtempfindliche Naphthochinonverbindung. Wenn bestimmte Bereiche des beschichteten Trägers mit aktinischer Strahlung belichtet werden, erfährt die lichtempfindliche Verbindung eine strukturelle Umwandlung, und die belichteten Bereiche der Beschichtung werden löslicher als die unbelichteten. Durch die Ausbildung eines solchen Löslichkeitsunterschieds lösen sich die belichteten Bereiche der lichtempfindlichen Schicht beim Eintauchen des Schichtträgers in eine alkalische Entwicklerlösung, während die unbelichteten Bereiche weitgehend unbeeinträchtigt bleiben. Die Folge dieses Verhaltens ist, daß auf dem Träger ein positives Reliefbild entsteht.

Für viele technische Anwendungen, insbesondere in der Mikroelektronik, muß ein Photoresist einen hohen Auflösungsgrad aufweisen, wenn er sehr kleine Linien- und Zwischenraumbreiten (in der Größenordnung von 1 μm) wiedergeben soll.

Die Fähigkeit eines Resists zur Wiedergabe sehr kleiner Abmessungen in der Größenordnung von 1 μm und darunter ist bei der Herstellung von LSI-Schaltungen auf Siliziumchips und ähnlichen Komponenten von größter Bedeutung. Die Schaltungsdichte auf einem solchen Chip kann nur durch eine Steigerung des Auflösungsvermögens des lichtempfindlichen Gemisches erhöht werden, sofern es sich um einen photolithographischen Prozeß handelt.

Zur Herstellung von VLSI-Schaltungen sind noch feinere Strukturen und bessere Materialien notwendig. Laut Stand der Technik wird vielfach auf der eigentlichen lichtempfindlichen Schicht eine Kontrastverstärkungsschicht aufgebracht.

Andererseits ist bekannt, daß die Brechung des zur Belichtung des Resists verwendeten Lichts, das durch die Maske in den Resist eingestrahlt wird, ein wesentlicher Grund ist für die Minderung der Bildauflösung und des Bildkontrastes, die mit dem jeweiligen Resist erzielt werden könnten. Dieser Umstand gewinnt um so mehr an Bedeutung, je kleiner die zu druckenden Schaltelemente werden.

Aus der EP-A-0 110 165 geht hervor, daß Bildauflösung und -kontrast durch Aufschleudern einer Schicht aus einem kontraststeigernden Mittel auf eine wärmebehandelte Resistschicht wesentlich verbessert werden können. In dem kontraststeigernden Mittel ist ein durch Licht bleichbarer Farbstoff enthalten, der innerhalb des gleichen Wellenlängenbereichs zersetzt wird, mit dem auch die Belichtung der darunterliegenden Resistschicht vorgenommen wird. Durch die Kontrastverstärkungsschicht soll die Auflösung des Bildes verbessert werden, wodurch gleichzeitig der Kontrast in der darunterliegenden Resistschicht erhöht werden soll: Denn das kontraststeigernde Mittel enthält einen das Licht bleichbaren Farbstoff, der das zur Belichtung der Resistschicht verwendete Licht absorbiert, so daß nach dem Ausbleichen des kontraststeigernden Mittels die von Licht getroffenen Stellen der Kontrastverstärkungsschicht eine größtmögliche Transparenz aufweisen, um dadurch eine wirkungsvolle bildmäßige Zersetzung der lichtempfindlichen Verbindung in der darunterliegenden Resistschicht durch das Licht zu erreichen. Die Entfärbung des Farbstoffes im kontraststeigernden Mittel sollte gleich schnell wie oder langsamer als die Zersetzung der in der Photoresistschicht enthaltenen lichtempfindlichen Verbindung vonstatten gehen. Die Kontrastverstärkungsschicht sollte eine möglichst große optische Dichte besitzen.

Durch die Kontrastverstärkungsschicht soll im Vergleich mit einem ohne diese Schicht hergestellten vergleichbaren Bild eine deutliche Kontrastverbesserung des fertigen Bildes erzielt werden. Außerdem soll die Dicke der Schicht möglichst gering gehalten werden, um eine genaue Focusierung zur Erzielung größtmöglicher Schärfe zu gewährleisten. Das kontraststeigernde Mittel soll bevorzugt eine gute Lagerfähigkeit besitzen und nach dem Aufschleudern auf einen Resist noch mehrere Stunden stabil bleiben. Sowohl das zur Herstellung des kontraststeigernden Mittels verwendete Lösemittelsystem als auch das zum Entfernen der Schicht benutzte Lösemittel sollten umweltfreundlich sein. Im übrigen sollte die Bildung einer Zwischenschicht im Grenzbereich von Kontrastverstärkungsschicht und Photoresistgemisch durch Mischen der beiden Schichten vermieden werden.

Die Lehre von EP-A-0 110 165 sieht die Verwendung eines Arylnitrons als lichtbleichbaren Farbstoff in Verbindung mit einem polymeren Bindemittel vor, das jedoch nur in umweltschädlichen organischen Lösemitteln löslich ist. L.F. Halle - schlägt in "A Water Soluble Contrast Enhancement Layer" (Wasserlösliche Kontrastverstärkungsschicht), Journal of Vacuum Science Technology , Bd. B3(1), Jan./Feb. 1985 eine Lösung des Umweltproblems vor. Der Vorschlag sieht die Verwendung einer Kontrastverstärkungsschicht aus Diphenylamin-p-diazoniumsulfat, Polyvinylalkohol, Wasser und Maleinsäure vor.

Die EP-A-0 161 660 sieht den Einsatz von Diazoniumsalzen, harzartigen Bindemitteln, Wasser und einer sauren Komponente, ebenfalls in einer Kontrastverstärkungsschicht vor. Durch die saure Komponente soll die Löslichkeit des Diazoniumsalzes im kontraststeigernden Mittel erleichtert und Kupplungsreaktionen zwischen dem Diazoniumsalz und den phenolischen Schichtbestandteilen verhindert werden.

Zweifellos sind kontraststeigernde Mittel auf Basis wäßriger Systeme umweltfreundlicher und führen auch nicht zur Ausbildung von Vermischungszonen mit dem Resist. Doch wird zur Herstellung dieser bekannten wäßrigen Diazoniumsalzsysteme stets eine saure Komponente benötigt, um die Löslichkeit der sonst nur schwerlöslichen Diazoniumsalze zu erhöhen und Kupplungsreaktionen der Diazoniumsalze zu unterdrücken. Bei der in EP-A-0 116 660 beschriebenen Lösung ist zur Verbesserung der Löslichkeit des Diazoniumsalzes beispielsweise eine nahezu äquimolare Menge p-Toluolsulfonsäure erforderlich.

Es bestand daher die Aufgabe, ein Aufzeichnungsmaterial bereitzustellen, dessen Kontrastverstärkungsschicht einen weit verbesserten Entwicklungskontrast liefert, eine gute Bildauflösung zeigt, sowie erhöhte Löslichkeit im Entwickler aufweist und zugleich auf keine umweltschädlichen organischen Lösemittel mehr angewiesen ist.

Die Erfindung wird gelöst durch ein Aufzeichnungsmaterial, in wesentlichen bestehend aus einem Träger, einer darauf aufgebrachten lichtempfindlichen Schicht, enthaltend ein in Wasser unlösliches, in wäßrig alkalischen und anorganischen Lösemitteln löslisches, zumindest aber quellbares Bindemittel und ein o-Chinondiazid, sowie eine Kontrastverstärkungsschicht, enthaltend ein durch Licht entfärbbares Diazoniumsalz und ein Polymeres als Bindemittel, dadurch gekennzeichnet, daß dieses Bindemittel in Wasser löslich, stark sauer und filmbildend ist.

Erfindungsgemäß können diesen Kontrastverteilungsschichten auch die in der EP-A-0 161 660 beschriebenen sauren Zusatzstoffen zugesetzt werden, bevorzugt kann jedoch auf diese verzichtet werden.

Durch Verwenden dieser erfindungsgemäß eingesetzten polymeren Bindemittel, die saure funktionelle Gruppen aufweisen, können wesentlich dünnere Kontrastverstärkungsschichten gleicher optischer Dichte erzeugt werden, mit der aber überraschenderweise gleichzeitig eine Steigerung des Entwicklungskontrastes erreicht wird.

Eine dünne kontraststeigernde Schicht ist auch deswegen von Vorteil, da dann eine bessere Bildauflösung nicht nur durch die Wirkung von optischen Belichtungsgeräten mit Objektiven von immer größeren Öffnungen getragen werden muß, sondern auch die ebenso zur Erzielung von immer feineren Bildern erforderliche genaue Focusierung des Lichtes gewährleistet ist. Eine dünnere Kontrastverstärkungsschicht ermöglicht sogar die Bebilderung einer dickeren Resistschicht. Ein weiterer Vorteil liegt in der besseren Lagerfähigkeit der Diazoniumsalze ohne den Säurezusatz gemäß der EP-A-0 161 660.

Unter Bildauflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, die einen hohen Grad an Flankensteilheit in den ausentwickelten belichteten Zwischenräumen eines durch diese Maske belichteten Photoresists gewährleistet.

Unter Entwicklungskontrast ist die Neigung einer linearen Kurve zu verstehen, die erhalten wird, indem man die nach der Belichtung mit unterschiedlicher Intensität und anschließender Entwicklung erhaltenen Schicht dicken gegen den Logarithmus der jeweiligen Belichtungsintensität anträgt.

Erfindungsgemäß enthält die auf den Träger aufgebrachte lichtempfindliche Schicht das lichtempfindliche o-Chinondiazid in ausreichender Menge, um eine Sensibilisierung der Schicht durch aktinisches Licht zu bewirken, so daß durch bildmäßiges Belichten und anschließendes Entwickeln eine bildmäßige Differenzierung erhalten wird. Die gesamte Schicht enthält mindestens ein harzartiges Bindemittel aus der Gruppe der Novolake, Polyvinylphenole und Polyvinylphenolcopolymeren, das dem o-Chinondiazid in ausreichender Menge zugesetzt wird, um das Entstehen eines gleichmäßigen Filmes zu bewirken.

Die Kontrastverstärkungsschicht enthält ein wasserlösliches, durch Licht entfärbbares Diazoniumsalz in ausreichender Menge, um bei Belichtung mit aktinischer Strahlung eine bildmäßige Differenzierung durch Ausbleichen zu erzielen, sowie ferner im Gemisch mit dem Diazoniumsalz ein stark saures, wasserlösliches, filmbildendes polymeres harzartiges Bindemittel, das in ausreichender Menge zugesetzt wird, um das Entstehen eines gleichmäßigen Filmes zu bewirken.

Erfindungsgemäß wird ferner ein Verfahren zur Herstellung eines bebilderten Aufzeichnungsmaterials vorgeschlagen, bei dem ein Schichtträger mit einer ersten lichtempfindlichen Schicht beschichtet wird, enthaltend ein lichtempfindliches o-Chinondiazid, das in ausreichender Menge eingesetzt wird, um eine Sensibilisierung der Schicht für aktinisches Licht zu bewirken, so daß durch bildmäßiges Belichten und anschließendes Entwikkeln eine bildmäßige Differenzierung erhalten wird, und mindestens ein harzartigen Bindemittel aus der Gruppe der Novolake, Polyvinylphenole und Polyvinylphenolcopolymeren, das dem o-Chinondiazid in ausreichender Menge zugesetzt wird, um das Entstehen eines gleichmäßigen Filmes zu bewirken; auf diese erste lichtempfindliche Schicht eine zweite lichtempfindliche Schicht aufgetragen wird, umfassend ein wasserlösliches, durch Licht entfärbbares Diazoniumsalz in ausreichender Menge, um bei Belichtung mit aktinischer Strahlung eine bildmäßige Differenzierung durch Ausbleichen zu erzielen, und, im Gemisch mit dem Diazoniumsalz, ein stark saures, wasserlösliches, filmbildendes polymeres harzartiges Bindemittel, das in ausreichender Menge zugesetzt wird, um das Entstehen eines gleichmäßigen Filmes zu bewirken; das so hergestellte Material mittels aktinischer Strahlung ausreichend belichtet wird, um ein Ausbleichen der belichteten Stellen der zweiten lichtempfindlichen Schicht zu bewirken, wobei diese entfärbten Stellen für die aktinische Strahlung durchlässig werden, während die nicht belichteten Stellen im wesentlichen für die aktinische Strahlung undurchlässig bleiben, und wobei die unter den durch die aktinische Strahlung entfärbten Stellen liegenden Teile der ersten lichtempfindlichen Schicht ebenfalls durch die aktinische Strahlung belichtet werden; und anschließend die gesamte zweite lichtempfindliche Schicht entfernt wird und die erste lichtempfindliche Schicht ausentwickelt wird.

Wie bereits vorstehend erwähnt wurde, besteht das erfindungsgemäße Aufzeichnungsmaterial aus einem Schichtträger, der mit einer ersten und einer zweiten lichtempfindlichen Schicht beschichtet ist. Als Schichtträger kann dabei jedes für die Aufnahme der ersten lichtempfindlichen Schicht geeignete Material eingesetzt werden. Bevorzugt besteht der Schichtträger jedoch aus Silicium, Aluminium, polymeren Harzen, Siliciumdioxid, dotiertem Siliciumdioxid, Siliciumnitrid, Tantal, Kupfer, polykristallines Silicium (polysilicon), Keramik, Aluminium/Kupfer-Mischungen, Galliumarsenid oder anderen Verbindungen der Elementgruppe III/V, bzw. aus Mischungen mehrerer der aufgezählten Komponenten.

Auf den Schichtträger wird gegebenenfalls eine haftvermittelnde Schicht aufgebracht, beispielsweise aus einem Hexaalkyldisilazan enthaltenden Gemisch.

Der Schichtträger wird mit einem lichtempfindlichen Gemisch beschichtet. Bevorzugt enthält dieses Gemisch einen bekannten Sensibilisator auf der Basis von o-Chinondiaziden sowie als Bindemittel ein Novolak- oder Polyvinylphenolharz, insbesondere Kresol-FormaldehydNovolakharze. Diese Bestandteile werden mit einem geeigneten Lösemittel versetzt; anschließend wird die Lösung auf den Schichtträger aufgetragen und getrocknet, bis sie nicht mehr klebrig ist.

Novolakharze, die für die Herstellung von lichtempfindlichen Gemischen verwendet werden können, sind bekannt. Ein Verfahren zur Herstellung dieser Novolake ist in "Chemistry and Application of Phenolic Resins" (Chemie und Anwendung von Phenolharzen), von A. Knop und W. Scheib, Springer Verlag, New York, 1979, Kapitel 4, beschrieben.

Dem Fachmann ist auch die Verwendung von o-Chinondiaziden bekannt. Diese werden in "Light Sensitive Systems" von J. Kosar, John Wiley & Sons, New York, 1965, Kapitel 7.4, beschrieben. Diese lichtempfindlichen Verbindungen, die Bestandteil der UV-empfindlichen Resistgemische der vorliegenden Erfindung sind, gehören zur Gruppe der substituierten lichtempfindlichen Naphthochinondiazide, wie sie üblicherweise in positiv-arbeitenden Photoresists verwendet werden. Solche Verbindungen sind zum Beispiel aus US-A 2,797,213, US-A-3,106,465, US-A-3,148,983, US-A 3,130,047, US-A-3,201,329, US-A-3,785,825 und US-A-3,802,855 bekannt. Geeignete lichtempfindliche Verbindungen sind zum Beispiel mit phenolischen Verbindungen, wie Hydroxybenzophenonen, insbesondere Trihydroxybenzophenonen oder Hydroxyalkylphenonen, kondensiertes 1,2-Naphthochinon-2-diazid-5-sulfonylchlorid und/oder 1,2-Naphthochinon-2-diazid-4-sulfonylchlorid.

Besondes bevorzugt sind Kondensationsprodukte aus 1,2-Naphthochinon-2-diazid-5-sulfonylchloriden und Trihydroxybenzophenonen, insbesondere 2,3,4-Trihydroxybenzophenon.

In bevorzugter Ausführungsform liegt der Gehalt an festen Bestandteilen des lichtempfindlichen Gemischs, d.h. an Bindemittel, vorzugsweise bei etwa 15 bis 99 Gewichtsprozent und an o-Chinondiaziden bei etwa 1 bis 85 Gewichtsprozent. Insbesondere ist das Bindemittel in einem Anteil von etwa 50 bis 90 Gewichtsprozent, und ganz besonders bevorzugt von etwa 65 bis 85 Gewichtsprozent, bezogen auf das Gewicht der festen Bestandteile des lichtempfindlichen Gemischs, in dem Gemisch enthalten. Der Anteil an o-Chinondiazid liegt insbesondere bei etwa 10 bis 50 Gewichtsprozent und ganz besonders bevorzugt bei etwa 15 bis 35 Gewichtsprozent, bezogen auf das Gewicht der festen Bestandteile des lichtempfindlichen Gemischs.

Die Auswahl des Lösemittels richtet sich nach dem jeweiligen Beschichtungsverfahren, der gewünschten Schichtdicke und den Trocknungsbedingungen. Für die erfindungsgemäßen Gemische eignen sich als Lösemittel beispielsweise Ether (z. B. Tetrahydrofuran), Alkohol (z. B. n-Propanol), Alkoholether (z. B. Ethylenglykolmonoethylether), Ester (z. B. Butylacetat), aromatische oder aliphatische Kohlenwasserstoffe (z. B. Xylol) oder Gemische aus den genannten Lösemitteln. Prinzipiell sind alle Lösemittel geeignet, die nicht irreversibel mit den Schichtbestandteilen reagieren. Bevorzugt werden teilveretherte Glykole, insbesondere Ehtylen- oder Propylenglykolmonehtylether oder deren Ester verwendet.

Als bevorzugtes Lösemittel sei hier Propylenglykolmonomethyletheracetat genannt. Auch Xylol, Butylacetat und Ethylenglykolmonoethyletheracetat sind geeignete Lösemittel.

Der Lösung aus Bindemittel, lichtempfindlicher Verbindung und Acetat können vor dem Aufbringen auf einen Schichtträger noch Zusätze, wie z. B. Farbmittel, Farbstoffe, Verlaufmittel, Weichmacher, Haftvermittler, Entwicklungsbeschleuniger, weitere Lösemittel und Tenside, z. B. nicht-ionische Tenside, zugegeben werden.

Farbstoffe, die als Zusätze für die erfindungsgemäßen lichtempfindlichen Gemische verwendet werden können, sind zum Beispiel Methylviolett 2B (C.I. 42 535), Kristallviolett (C.I. 42 555), Malachitgrün (C.I. 42 000), Viktoriablau B (C.I. 44 405) und Neutralrot (C.I. 50 040). Diese Farbstoffe werden in einer Menge von 1 bis 10 Gewichtsprozent, bezogen auf das Gesamtgewicht von Bindemittel und lichtempfindlicher Verbindung, zugesetzt. Die Farbstoffzusätze verringern die Rückstreuung von Licht vom Schichtträger und tragen so zu einer verbesserten Bildauflösung bei. Verlaufmittel können in einer Menge bis zu 5 Gewichtsprozent, bezogen auf das Gesamtgewicht von Bindemittel und lichtempfindlicher Verbindung, eingesetzt werden.

Geeignete Weichmacher sind zum Beispiel Phosphorsäure-tri(ß-chlorethyl)-ester, Stearinsäure, Dicampher, Polypropylen, Acetalharze, Phenoxyharze und Alkydharze, die in Anteilen von 1 bis 10 Gewichtsprozent, bezogen auf das Gesamtgewicht von Bindemittel und lichtempfindlicher Verbindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler sind zum Beispiel β-(3,4-Epoxycylohexyl)-ethyltrimethoxysilan, p-Methyldisilanmethylmethacrylat, Vinyltrichlorsilan und γ-Aminopropyltriethoxysilan in einem Anteil bis zu 4 Gewichtsprozent, bezogen auf das Gesamtgewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das Gesamtgewicht von Bindemittel und lichtempfindlicher Verbindung, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen Anwendungen eingesetzt, bei denen es in erster Linie auf die Entwicklungsgeschwindigkeit ankommt, auch wenn dabei evtl. ein gewisser Grad an Kontrast geopfert wird; denn während die belichteten Bereiche der lichtempfindlichen Schicht durch den Zusatz von Beschleunigern vom Entwickler schneller gelöst werden, bewirken die Entwicklungsbeschleuniger gleichzeitig auch einen größeren Verlust an lichtempfindlicher Schicht aus den unbelichteten Bereichen.

Als nicht-ionische Tenside können zum Beispiel Nonylphenoxy-poly(ethylenoxy)-ethanol, Octylphenoxy(ethylenoxy)-ethanol, und Dinonylphenoxy-poly(ethylenoxy) ethanol in einem Anteil bis zu 10 Gewichtsprozent, bezogen auf das Gesamtgewicht von Bindemittel und lichtempfindlicher Verbindung, verwendet werden.

Die fertige Photoresistlösung kann nach einem der in der Photoresisttechnik üblichen Verfahren, wie Tauchen, Sprühen und Aufschleudern, auf einen Träger aufgebracht werden. Für das Aufschleudern kann zum Beispiel der Prozentanteil an Feststoffen in der Resistlösung so eingestellt werden, daß sich in Abhängigkeit von der im Einzelfall verwendeten Aufschleudervorrichtung und der für den Aufschleudervorgang angesetzten Zeitspanne eine Beschichtung in der gewünschten Dicke ergibt.

Im Anschluß an das Aufbringen der Resistlösung auf den Schichtträger erfolgt eine Wärmebehandlung bei etwa 80 bis 105° C, bis das Lösemittel praktisch vollständig verdampft ist und eine dünne lichtempfindliche Schicht von nur etwa 1 μm Dicke auf dem Schichtträger erhalten wird.

Auf die so erhaltene Schicht wird die erfindungsgemäße Kontrastverstärkungsschicht aufgetragen, d.h. eine Schicht aus einem kontraststeigernden Material, enthaltend ein wasserlösliches, durch Licht entfärbbares Diazoniumsalz und ein polymeres Bindemittel enthält, das eine starke Säure darstellt. Die einzelnen Komponenten werden in Wasser gemischt.

Erfindungsgemäß sind praktisch alle aus dem Stand der Technik bekannten wasserlöslichen Diazoniumsalze als durch Licht entfärbbare Diazoniumsalze in der Kontrastverstärkungsschicht geeignet. Dazu gehören beispielsweise die Diazoniumsalze, die von J. Kosar in "Light Sensitive Systems" (Lichtempfindliche Systeme), 1965, J. Wiley Sons Inc., New York, S. 194, und von M.S. Dinaburg in "Photosensitive Diazo Compounds and Their Uses" (Lichtempfindliche Diazoverbindungen und ihre Anwendung), 1964, The Focal Press, beschrieben sind.

Der Anteil an Diazoniumsalz beträgt normalerweise 10 bis 50 Gewichtsprozent, bevorzugt 20 bis 40 Gewichtsprozent, jeweils bezogen auf die festen Schichtbestandteile. Der Anteil an polymerem Bindemittel, das eine starke Säure darstellt, beträgt gewöhnlich 50 bis 90 Gewichtsprozent, bevorzugt 60 bis 80 Gewichtsprozent, jeweils bezogen auf die festen Schichtbestandteile.

In den meisten Systemen hat sich eine wäßrige Lösung eines Diazoniumsalzes mit einem pH-neutralen polymeren Bindemittel als recht instabil erwiesen. Auch basische Polymere und schwach saure Polymere scheiden aus. Erfindungsgemäß eignen sich nur stark saure Polymere gut. Dazu zählen im allgemeinen solche Polymere, die in wäßriger Lösung einen pH-Wert von 1 oder weniger besitzen.

Als Beispiele für stark saure Polymergruppen seien $-SO_3H$- und $-OSO_3H$-Gruppen genannt. Entsprechende Polymere sind beispielsweise Polystyrolsulfonsäure, Polyethylensulfonsäure, Polyvinylsulfonsäure und Polyvinylphenylsulfonsäure, von denen Polystyrolsulfonsäure bevorzugt eingesetzt wird. Es ist auch möglich, Copolymere von Vinylsulfonsäure oder Styrolsulfonsäure herzustellen und zu verwenden. Die Eigenschaften der Kontrastverstärkungsschichten, enthaltend saure Polymere dieser Art, können durch entsprechende Zusätze, wie Tenside, Entschäumungsmittel, usw. verbessert werden.

Dadurch, daß die polymeren Sulfonsäuren sowohl als Bindemittel als auch als Stabilisator für die Diazoniumsalze wirken, können sie die Ausbildung dünnster Schichten gewährleisten und daher im Vergleich zu äquimolar eingesetzten monomeren Arylsulfonsäuren das Absorptionsvermögen der Kontrastverstärkungsschicht erhöhen und gleichzeitig aber auch das Aussalzen bestimmter Diazoniumsalze verhindern.

Die Kontrastverstärkungsschichten können in einer Dicke von etwa 0,5 μm Dicke aufgeschleudert werden, die einen höheren Kontrast ermöglichen, gleichzeitig aber in ihrer Wirkungsweise

herkömmlichen Kontrastverstärkungsschichten entsprechen. Je höher die Konzentration des Diazoniumsalzes ist, desto dünner kann die Kontrastverstärkungsschicht ausgebildet sein.

Die erfindungsgemäß einfache Zusammensetzung der Schicht - es werden lediglich zwei Komponenten in Wasser gelöst - ermöglicht eine unkomplizierte Herstellungsweise und Qualitätskontrolle und gleichzeitige Wahrung der bekannten Vorteile eines Kontrastverstärkungsmittels. Die Schicht kann zur Verdampfung des Wassers luftgetrocknet oder wärmebehandelt werden, ohne daß es zu einem Abbau der festen Bestandteile des kontraststeigernden Mittels kommt.

Bei der bildmäßigen Belichtung des so hergestellten Doppelschichtmaterials bestehend aus lichtempfindlicher Schicht und Kontrastverstärkungsschicht dringt das Licht durch die Kontrastverstärkungsschicht in die lichtempfindliche Schicht ein. Die Kontrastverstärkungsschicht wird anschließend durch Abspülen mit Wasser und/oder im nachfolgenden Entwicklungsschritt entfernt. Die darunterliegende lichtempfindliche Schicht wird mit einem geeigneten wäßrig-alkalischen Entwickler entwickelt, beispielsweise mit AZ Developer (Hersteller AZ Photoresist Products Group der Hoechst Celanese Corporation, Somerville, New Jersey, USA).

Üblicherweise wird mit aktinischer Strahlung bestrahlt, insbesondere mit UV-Strahlung.

Die Kontratverstärkungsschicht kann auch mit Licht nur einer Wellenlänge belichtet werden.

In der Tat entfärbt sich das kontraststeigernde Mittel beim bildmäßigen Belichten und wird an den belichteten Stellen farblos. Die aktinische Strahlung dringt durch diese transparenten, entfärbten Stellen hindurch, so daß die darunterliegende lichtempfindliche Schicht bildmäßig belichtet wird. An den unbelichteten Stellen der Kontrastverstärkungsschicht wird das Eindringen einfallender Lichtstrahlen verhindert; auf diese Weise wird eine bildmäßige Differenzierung ermöglicht. Vorzugsweise besitzen die unbelichteten Stellen der Kontrastverstärkungsschicht eine Durchlässigkeit für die Wellenlängen des Lichtes, mit denen belichtet wird, von weniger als 10 % für Licht der zur Belichtung verwendeten Wellenlänge.

Lichtempfindliche Verbindungen auf der Basis von o-Chinondiaziden ergeben zwar im allgemeinen positivarbeitende Systeme, doch ist die Erfindung nicht auf derartige Systeme beschränkt, obwohl sie diese insbesondere betrifft. Die Erfindung beinhaltet auch die sogenannten Bildumkehrverfahren, bei denen durch entsprechende Zusätze zu den lichtempfindlichen Gemischen und/oder durch zusätzliche Verfahrensschritte negative Bilder in den o-Chinondiazidschichten erhalten werden können. Dies ist zum Beispiel möglich, indem man der lichtempfindlichen Schicht ein Vernetzungsmittel, wie ein Dimethylol-p-kresol, zusetzt.

Anhand der folgenden Beispiele werden Herstellung und Verwendung der erfindungsgemäßen Gemische näher erläutert, ohne daß jedoch eine Beschränkung auf diese beispielhaften Ausführungen stattfinden soll.

Beispiel 1 (Vergleichsbeispiel)

Aus folgenden Bestandteilen wird ein positiv-arbeitendes lichtempfindliches Gemisch hergestellt:
24,4 Gew.-% eines Kresol-Novolaks mit einem Erweichungsbereich von 105 bis 120° C,
7,5 Gew.-% eines Kondensationsproduktes aus 2,3,4-Trihydroxybenzophenon und 1,2-Naphthochinon-2-diazid-5-sulfonylchlorid als lichtempfindliche Verbindung und
68,1 Gew.-% Propylenglykolmethyletheracetat.

Die Resistlösung wird auf einen Schichtträger aufgeschleudert und 30 Minuten bei 90° C in einem Umlufttrockenschrank getrocknet, so daß eine 1,8 $\mu$m dicke Schicht erhalten wird. Der mit diesem Resist erzielbare Bildkontrast wird durch Belichten der Schicht durch eine Glasmaske abgestufter, bekannter optischer Dichte bestimmt. Zur Belichtung wird eine Breitbandbelichtungsvorrichtung vom Typ Perkin Elmer Microalign 220 verwendet.

Die Entwicklung erfolgt innerhalb von 30 Sekunden mit einem Entwickler folgender Zusammensetzung:
5,3 g Natriummetasilikat x 9 $H_2O$,
3,4 g Trinatriumphosphat x 12 $H_2O$,
0,3 g Natriumdihydrogenphosphat und
91 g vollentsalztes Wasser.

Der Entwickler hat eine Konzentration von 0,28 n.

Anschließend wird die Schichtdicke gemessen, die nach der Belichtung mit einer bestimmten Belichtungsintensität und dem Entwickeln vorhanden ist. Die Neigung der Kurve, die durch Antragen der zurückgebliebenen Schichtdicke gegen den Logarithmus der Belichtungsintensität erhalten wird, gibt den Entwicklungskontrastwert des Resists an. Er beträgt in diesem Fall 3,1.

Beispiel 2

Aus folgenden Bestandteilen wird ein kontraststeigerndes Mittel hergestellt:
120 g Polystyrolsulfonsäure (15%-ige Lösung in Wasser),
30 g Wasser,
3 g Isopropanol und
157 mmol Diphenylamin-p-diazoniumchlorid.

Dieses kontraststeigernde Mittel wird auf die nach den Angaben von Beispiel 1 hergestellte und getrocknete positiv-arbeitende lichtempfindliche Schicht aufgeschleudert, so daß eine Kontrastverstärkungsschicht von 0,6 $\mu$m Dicke erhalten wird.

Das in dieser Weise hergestellte Doppelschichtmaterial wird nach den Angaben von Beispiel 1 belichtet. Anschließend wird ebenfalls entsprechend Beispiel 1 der Kontrast bestimmt. Der ermittelte Entwicklungskontrastwert beträgt in diesen Fall 7,5.

Beispiel 3

Aus folgenden Bestandteilen wird ein kontraststeigerndes Mittel hergestellt:
120 g Polystyrolsulfonsäure (15%-ige Lösung in Wasser),
30 g Wasser,
3 g Isopropanol und
157 mmol 3-Methyl-4-pyrrolidinbenzol-p-diazoniumchlorid-zinkchloridmonohydrat.

Es wird verfahren wie in Beispiel 2. Der ermittelte Entwicklungskontrastwert ist 5,8.

Beispiel 4

Aus folgenden Bestandteilen wird ein kontraststeigerndes Mittel hergestellt:
120 g Polystyrolsulfonsäure (15%-ige Lösung in Wasser),
30 g Wasser,
3 g Isopropanol und
138 mmol 2,5-Diethoxy-4-morpholin-benzoldiazoniumfluorborat.

Es wird verfahren wie in Beispiel 2. Der ermittelte Kontrastwert ist 5,8.

Die Beispiele zeigen, daß durch Verwendung des erfindungsgemäßen lichtempfindlichen Aufzeichnungsmaterials, enthaltend eine Kontrastverstärkungsschicht, eine deutliche Steigerung des Entwicklungskontrasts erzielt wird. Der genaue Entwicklungskontrastwert und die jeweilige Lichtempfindlichkeit hängen von der richtigen Abstimmung zwischen dem Absorptionsbereich eines bestimmten Diazoniumsalzes und den im Einzelfall zur Belichtung verwendeten Licht ab. Die Kontrastverstärkungsschicht kann auch mit Licht nur einer Wellenlänge belichtet werden.

**Ansprüche**

1. Aufzeichnungsmaterial, im wesentlichen bestehend aus einem Träger, einer darauf aufgebrachten lichtempfindlichen Schicht, enthaltend ein in Wasser unlösliches, im wäßrigem Alkali und in organischen Lösungsmitteln lösliches, zumindest aber quellbares Bindemittel und ein o-Chinondiazid, sowie eine Kontrastverstärkungsschicht, enthaltend ein durch Licht entfärbbares Diazoniumsalz und ein Polymeres als Bindemittel, dadurch gekennzeichnet, daß dieses Bindemittel in Wasser löslich ist, stark sauer und filmbildend ist.

2. Aufzeichnungsmaterial nach Anspruch 1, dadurch gekennzeichnet, daß die lichtempfindliche Schicht positiv arbeitend ist.

3. Aufzeichnungsmaterial nach Anspruch 1, dadurch gekennzeichnet, daß die lichtempfindliche Schicht zusätzlich ein Vernetzungsmittel, insbesondere Dimethylol-p-Kresol enthält, und deswegen negativ arbeitend ist.

4. Aufzeichnungsmaterial nach einem oder mehreren der Ansprüche 1 bis 3, dadurch gekennzeichnet, daß als o-Chinondiazid ein Kondensationsprodukt aus 1,2-Naphthochinon-2-diazid-5- und/oder -4-sulfonylchlorid mit einem Hydroxybenzophenon oder einem Hydroxyalkylphenon eingesetzt wird.

5. Aufzeichnungsmaterial nach Anspruch 4, dadurch gekennzeichnet, daß das o-Chinondiazid ein Kondensationsprodukt aus 1,2-Naphthochinon-2-diazid-5-sulfonylchlorid und 2,3,4-Trihydroxybenzophenon ist.

6. Aufzeichnungsmaterial nach einem oder mehreren der Ansprüche 1 bis 5, dadurch gekennzeichnet, daß die Kontrastverstärkungsschicht ein Polymeres mit einem pH-Wert von $\leq 1$ aufweist.

7. Aufzeichnungsmaterial nach Anspruch 6, dadurch gekennzeichnet, daß das Polymere $-SO_3H$ und/oder $-OSO_3H$-Gruppen enthält.

8. Aufzeichnungsmaterial nach einem oder mehreren der Ansprüche 1 bis 7, dadurch gekennzeichnet, daß die Kontrastverstärkungsschicht neben Wasser weitere Zusätze wie Tenside, Entsäuerungsmittel enthält.

9. Verfahren zur Herstellung eines Aufzeichnungsmaterials gemäß den Ansprüchen 1 bis 8 sowie eines daraus hergestellten Resistmusters, dadurch gekennzeichnet, daß das in einem Lösungsmittel gelöste, lichtempfindliche Gemisch auf einem ggf. mit einem Haftvermittler vorbehandelten Träger aufgetragen wird, die Schicht getrocknet wird bis sie nicht mehr klebrig ist, anschließend das kontraststeigernde Mittel aufgeschleudert und die Schicht zur Verdampfung des Wassers luftgetrocknet oder wärmebehandelt wird, daß das Aufzeichnungsmaterial mit aktinischer Strahlung bildmäßig belichtet, die Kontrastverstärkungsschicht durch Abspülen mit Wasser und/oder während der Entwicklung der lichtempfindlichen Schicht durch einen geeigneten wäßrig-alkalischen Entwickler entfernt wird.

10. Verfahren nach Anspruch 9, dadurch gekennzeichnet, daß die lichtempfindliche Schicht ein Vernetzungsmittel enthält, die lichtempfindliche Schicht während der bildmäßigen Belichtung mit aktinischer Strahlung vernetzt wird und nach dem Entwickeln mit einem wäßrigalkalischen Entwickler ein negatives Bild entsteht.